# EUROPEAN PATENT SPECIFICATION

(11) **EP 3 118 349 B1**
(45) Date of publication and mention of the grant of the patent: **04.07.2018**
(21) Application number: 15176703.5
(22) Date of filing: 14.07.2015
(51) Int. Cl.: C23C 16/54, C23C 16/455, C23C 16/44

(54) **DEPOSITION SOURCE, DEPOSITION APPARATUS AND METHOD OF OPERATING THEREOF**
ABSCHEIDUNGSVORRICHTUNG UND VERFAHREN ZUM BETRIEB DAVON
SOURCE DE DÉPÔT, APPAREIL DE DÉPÔT ET SON PROCÉDÉ DE FONCTIONNEMENT

(43) Date of publication of application: 18.01.2017
(73) Proprietor: Applied Materials, Inc., Santa Clara, CA 95054 (US)
(72) Inventor: RIES, Florian, 63825 Westerngrund (DE); GOIHL, Thomas, 63683 Eschau (DE)
(74) Representative: Zimmermann & Partner Patentanwälte mbB

(56) References cited:
- JP-A- 2009 030 166
- JP-A- 2011 071 222
- US-B1- 6 168 698

## Description

### TECHNICAL FIELD

Embodiments described herein relate to a deposition source for coating a substrate, a deposition apparatus with at least one deposition source for coating a substrate, and methods of operating thereof. Embodiments particularly relate to a deposition source for coating a movable substrate, and particularly a flexible substrate, in a source housing to be evacuated, a deposition apparatus for coating a movable substrate with a process chamber for holding the substrate and a source housing for coating processing, and methods of operating a deposition apparatus for coating a movable substrate. Particularly, embodiments relate to a deposition source for coating a movable substrate, a deposition apparatus for coating a movable substrate, and a method of operating a deposition apparatus for coating a movable substrate.

### BACKGROUND

Substrates such as flexible substrates are regularly processed while being moved past processing equipment. Processing may comprise coating of a flexible substrate with a desired material, e.g. metal, particularly aluminum, semiconductors or dielectric materials, conducted on a substrate for the desired applications. Particularly, coating of metal, semiconductor or plastic films or foils is in high demand in the packaging industry, semiconductor industry and other industries. Systems performing this task generally include a processing drum, e.g., a cylindrical roller, coupled to a processing system for moving the substrate, on which at least a portion of the substrate is processed. So called roll-to-roll coating systems allowing substrates to be coated while being moved on the guiding surface of a processing drum can provide for a high throughput.

Typically, an evaporation process, such as a thermal evaporation process, can be utilized for depositing thin layers of coating material onto the flexible substrate. Therefore, roll-to-roll deposition systems are also experiencing a strong increase in demand in the display industry and the photovoltaic (PV) industry. For example, touch panel elements, flexible displays, and flexible PV modules result in an increasing demand for depositing suitable layers in roll-to-roll coaters with low manufacturing costs. Such devices are typically manufactured with several layers of coating material, which may be produced in roll-to-roll coating apparatuses which successively utilize several deposition sources. Each deposition source may be adapted for coating the substrate with a particular coating material while the substrate is being moved towards the next deposition source. Typically, PVD (physical vapour deposition) and/or CVD (chemical vapour deposition) processes and particularly PECVD (plasma enhanced chemical vapour deposition) processes are used for coating.
Documents JP 2011 071222 A, JP 2009 030166 A, and US 6 168 698 B1 relate to vacuum apparatuses configured to coat movable substrates, respectively. A process gas is introduced in the vacuum apparatus, interacts with the substrate, and is removed from the apparatus, respectively.

Over the years, layers in display devices have evolved into multiple layers with each layer serving a different function. Multiple layers may be deposited onto multiple substrates via multiple deposition sources. Transferring multiple substrates through multiple vacuum chambers may decrease the throughput. Therefore, there is the need in the art for an efficient method and apparatus for coating movable substrates with various layers, wherein a high substrate throughput can be ensured while maintaining an improved coating efficiency and accuracy.

### SUMMARY

In light of the above, according to the independent claims, a deposition source for coating a movable substrate, a deposition apparatus for coating a movable substrate including at least one deposition source, and methods of operating a deposition apparatus are provided. Further aspects, advantages, and features are apparent from the dependent claims, the description, and the accompanying drawings.

According to embodiments described herein, a deposition source for coating a movable substrate is provided. The deposition source includes: a source housing to be attached to a process chamber, e.g. a vacuum process chamber, in such a way that a substrate can be moved past an open front side of the source housing during deposition; a gas inlet for introducing a process gas into a coating processing region of the source housing; an evacuation outlet for removing the process gas from a pumping region of the source housing; and an evacuation partition unit arranged between the coating processing region and the pumping region with at least one opening defining a process gas flow path from the coating processing region into the pumping region.

In embodiments, the evacuation partition unit includes a plurality of openings which define the process gas flow path from the coating processing region into the pumping region. In some implementations, a wire or filament assembly is arranged in the coating processing region, so that the deposition source is configured for HWCVD (hot wire chemical vapour deposition) coating processing.

According to a further aspect, a deposition apparatus for coating a movable substrate is provided. The deposition apparatus includes a source housing and a process chamber. The process chamber is connected to the source housing and provided with a substrate support, the substrate support including a substrate guiding surface for moving a substrate past an open front side of the source housing. The source housing includes: a gas inlet for introducing a process gas into a coating processing region of the source housing; an evacuation outlet for removing the process gas from a pumping region of the source housing; and an evacuation partition unit arranged between the coating processing region and the pumping region with at least one opening defining a process gas flow path from the coating processing region into the pumping region. In embodiments, the evacuation partition unit includes at least one plurality of openings which define the process gas flow path from the coating processing region into the pumping region.

Embodiments are also directed to methods of operating a deposition apparatus for coating a substrate. The method includes moving a substrate past an open front side of a source housing, introducing a process gas into a coating processing region of the source housing, wherein the process gas follows a process gas flow path from the processing region into a pumping region of the source housing through at least one opening of an evacuation partition unit arranged between the coating processing region and the pumping region, and removing the process gas from the pumping region.

Embodiments are also directed at apparatuses for carrying out the disclosed methods and include apparatus parts for performing the individual method actions. This method may be performed by way of hardware components, a computer programmed by appropriate software, by any combination of the two or in any other manner. Furthermore, embodiments are also directed at methods of operating the described apparatus.

Further advantages, features, aspects and details that can be combined with embodiments described herein are evident from the dependent claims, the description and the drawings.

### BRIEF DESCRIPTION OF THE DRAWINGS

So that the manner in which the above recited features of the present invention can be understood in detail, a more particular description of the invention, briefly summarized above, may be had by reference to embodiments. The accompanying drawings relate to embodiments of the invention and are described in the following:
FIG. 1A shows a schematic sectional view of a deposition source for depositing a thin film on a movable substrate according to embodiments described herein;
FIG. 1B shows the deposition source of FIG. 1A in a sectional view along C-C for illustrating a process gas flow path within the source housing;
FIG. 2A shows a schematic sectional view of a deposition source for coating a movable substrate with a wire assembly for HWCVD operation according to embodiments described herein;
FIG 2B shows the deposition source of FIG. 2A in a sectional view along C-C, intersecting the openings in the evacuation partition unit for illustrating a process gas flow path within the source housing;
FIG. 3A shows a schematic sectional view of a deposition source for coating a movable substrate with a wire assembly for HWCVD operation according to embodiments described herein;
FIG 3B shows the deposition source of FIG. 3A in a sectional view along C-C, intersecting the openings in the evacuation partition unit for illustrating a process gas flow path within the source housing;
FIG. 4A shows a sectional view of a deposition source for coating a movable substrate, wherein the sectional plane runs through a closed portion of the evacuation partition unit, according to embodiments described herein;
FIG. 4B shows a sectional view of the deposition source of FIG. 4A, wherein the sectional plane runs through an opening of the evacuation partition unit;
FIG. 5A shows a perspective view of a showerhead assembly in combination with gas shielding plates to be used in a deposition source according to embodiments described herein;
FIG. 5B is an enlarged view of a portion of the showerhead assembly of FIG. 5A;
FIG. 6 is a perspective view of part of the showerhead assembly of FIG. 5A;
FIG. 7 shows a perspective view of a deposition source according to embodiments described herein;
FIG. 8 shows a simplified schematic view of a deposition apparatus with two deposition sources according to embodiments described herein; and
FIG. 9 shows a flowchart of a method of operating a deposition apparatus according to embodiments described herein.

### DETAILED DESCRIPTION OF EMBODIMENTS

Reference will now be made in detail to the various embodiments described herein, one or more examples of which are illustrated in the figures. Within the following description of the drawings, the same reference numbers refer to same components. Generally, only the differences with respect to individual embodiments are described. Each example is provided by way of explanation and is not meant as a limitation. Further, features illustrated or described as part of one embodiment can be used on or in conjunction with other embodiments to yield yet a further embodiment. It is intended that the description includes such modifications and variations.

A deposition source according to embodiments described herein is configured for coating a movable substrate. Movable substrates may be flexible substrates or webs which can be characterized as being bendable. The term "web" may be synonymously used with the term "foil", "strip", or "flexible substrate". For example, the web, as described in embodiments herein, may be a foil or another flexible material substrate. However, as described in more detail below, the benefits of embodiments described herein may also be provided for non-flexible substrates or carriers of other inline-deposition systems, which may be moved past or through a processing region of the deposition source during coating processing. Yet, particular benefit can be achieved for flexible substrates and apparatuses for manufacturing devices on flexible substrates.

Embodiments described herein relate to deposition sources for coating movable substrates, e.g. for depositing one or several thin films on the substrate. Deposition sources may be configured as CVD deposition sources for coating a substrate by chemical vapour deposition, e.g. as PECVD and/or HWCVD deposition sources, or deposition sources may be configured as PVD deposition sources for coating a substrate by physical vapour deposition, e.g. as sputter deposition sources.

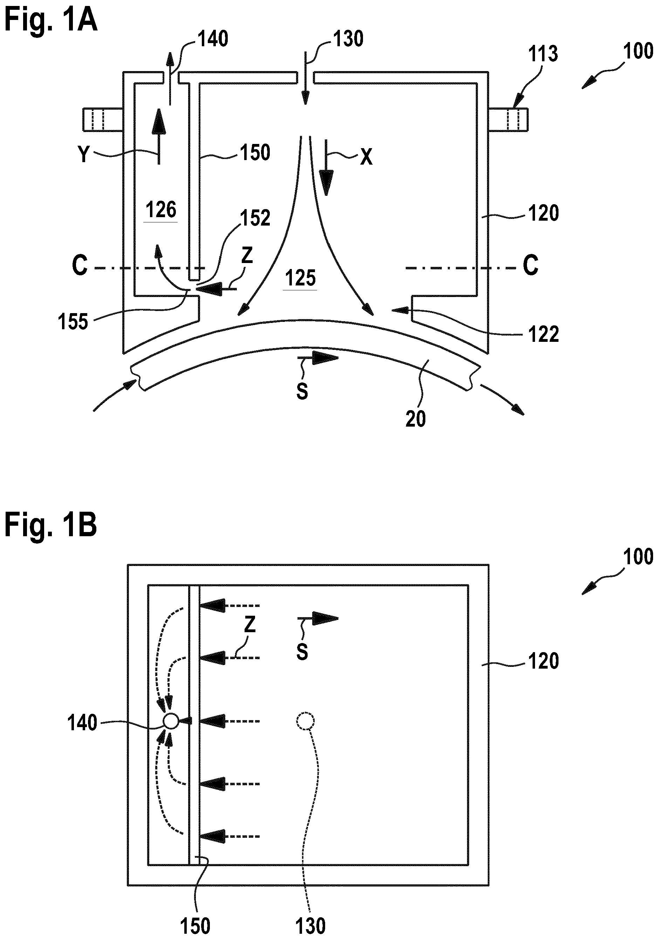

As shown in FIG. 1A, the deposition source 100 according to some embodiments includes a source housing 120 with a coating processing region 125 which may occupy most of the inner volume of the source housing 120. In order to allow for a substrate 20 to be moved past or through the processing region 125 of the source housing 120, the source housing is provided with an open side 122. The open side 122 of the source housing may be provided as an opening in an outer wall of the source housing, wherein the substrate to be coated may be moved past the opening. In embodiments, a front side of the source housing may be partially or completely open for allowing a substrate to be moved past the open front side. In some embodiments, the open front side may be provided with slits in the outer wall of the source housing, so that the substrate can enter the source housing via an entrance slit and leave the source housing via an exit slit. The substrate 20 to be coated may be moved past the open side 122 of the source housing at a predetermined velocity during deposition. As the source housing 120 includes an opening in the outer wall and is hence not fully closed, the source housing may also be referred to as a source casing or source cover.

The deposition source 100 is adapted to be mounted to a process chamber, e.g. a vacuum process chamber, for holding and transporting the substrate 20 in such a way that the substrate may be moved past the open front side 122 of the source housing. The process chamber as well as the substrate are not a part of the deposition source. However, the source housing in combination with the process chamber may provide for an encapsulated deposition apparatus with an inner volume to be evacuated during coating processing. The deposition source may be provided with fastening elements 113, e.g. a vacuum flange, a vacuum seal, bolt holes, screws and/or bolts, for attaching the deposition source 100 to a process chamber in a gas-tight manner.

As is shown in FIG. 1A, the source housing 120 of the deposition source 100 includes at least one evacuation outlet 140 for evacuating the source housing 120. During coating processing, vacuum is typically generated in the source housing 120 by connecting an evacuation apparatus, e.g. a vacuum pump (not shown), to the evacuation outlet. Then, various vacuum deposition techniques can be used to deposit a thin-film on the substrate, particularly chemical vapour deposition techniques.

FIG. 1A shows a deposition source 100 for being utilized in a roll-to-roll deposition apparatus for performing chemical vapour deposition. A process gas is introduced into the coating processing region 125 via a gas inlet 130. The process gas streams along a process gas flow path 155 from the gas inlet 130 towards the open front side 120 of the source housing 120, where the substrate to be coated is located. Then, the process gas reacts and/or decomposes on the substrate surface to produce a desired solid phase deposit. Typically, volatile residual products or by-products are generated on the substrate surface and may stream together with unconsumed process gas towards the evacuation outlet 140 (hereinafter also referred to as process gas), where the process gas is exhausted. Therefore, the necessary vacuum conditions can be maintained within the coating processing region 125 of the source housing 120.

Typically, it is beneficial to maintain a desired and particularly uniform process gas flow distribution in specific regions in the coating processing region 125, which may be difficult to achieve in the case of a source housing 120 with an open front side. In this case, it is typically not possible to provide the evacuation outlet immediately next to the substrate, because the substrate is movable and, during processing, the open front side does not leave any free space for providing a suction outlet. In particular, the source housing front side may be partially or completely covered by the moving substrate during deposition, so that the substrate may block a potential process gas removal path in a forward direction and may prevent a uniform removal of the residual process gas from regions all around the substrate.

According to the embodiments described herein, the gas distribution is improved by specific configurations of the gas inlet 130 and the evacuation outlet 140, and the process gas flow distribution inside the source housing 125 can be made more uniform, also in the case of a source housing 120 of a web coating or roll-to-roll coating apparatus. To achieve this goal, the evacuation outlet 140 is configured for removing the process gas from a pumping region 126 of the source housing 120. Further, an evacuation partition unit 150 is arranged between the coating processing region 125 and the pumping region 126 with at least one opening 152 defining a process gas flow path 155 from the coating processing region 125 into the pumping region 126.

According to some implementations, the evacuation partition unit 150 has at least one plurality of openings 152, the plurality of openings defining the process gas flow path 155 from the coating processing region 125 into the pumping region 126.

In other words, the inner volume of the source housing 120 is divided into at least two regions, namely the coating processing region 125 and the pumping region 126 which are separated by the evacuation partition unit 150, wherein one or several openings 152 in the evacuation partition unit enable for a fluid communication between the two regions. The process gas flow path 155 may run through the source housing from the gas inlet 130 towards the open front side of the source housing. Then, the process gas flow path 155 may be curved to run sideways and/or in a backward direction through the at least one opening 152 in the evacuation partition unit 150 into the pumping region 126. The process gas is then removed from the pumping region 126 via the evacuation outlet 140, which is provided in the pumping region 126.

By providing a pumping region 126 separated from, but in fluid communication with the coating processing region 125 via the evacuation partition unit 150, a more uniform process gas distribution can be provided. Said uniform process gas flow distribution within the coating processing region 125 near the substrate is illustrated in FIG. 1B, wherein a schematic sectional view through the source housing 120 of FIG. 1A is shown along line C-C. The positions of the gas inlet 130 and of the evacuation outlet 140 are indicated in broken lines.

The at least one opening 152 provided in the evacuation partition unit 150 may have an arbitrary shape, e.g. a slit, a circle, a square, an oval etc. By providing a plurality of openings in the evacuation partition unit, wherein each of the openings is located near a different portion of the substrate 20 to be coated, the process gas can be sucked away in a more homogenous way from the substrate. Further, the overall pressure in the coating processing region can be kept at a more constant level. For example, five, ten, twenty or more openings may be provided in the evacuation partition unit 150, e.g. at an equal spacing.

The evacuation partition unit 150, as is exemplarily shown in FIG. 1A, may be at least partially provided as an inner wall protruding into the inner volume of the source housing 120, which divides the inner volume into two regions. The openings 152 provided in the evacuation partition unit 150 may be located near the open front side of the source housing 120, so that the process gas may enter the openings sideways just after having contacted the substrate surface. In order to provide for a particularly uniform process gas distribution, the openings may be arranged at least partially around the open front side of the source housing, for example at one, two or more sides of the open front side and/or may extend along the full width of the substrate to be coated.

As a forward gas flow direction may typically be blocked by the moving substrate during deposition, the openings 152 may be provided in an inner side wall of the source housing, the inner side wall laterally confining the coating processing region. In embodiments described herein, the openings 152 may be provided in at least two inner side walls of the source housing, particularly in two lateral inner side walls opposing each other in a moving direction S of the substrate 20. In this case, the process gas flow path may be curved, whereas a first main direction X of the process gas flow path in the coating processing region runs in a rear-front direction from the gas inlet to the open front side, and a third main direction Z of the process gas flow path runs sideways through the openings into the pumping region, as is, e.g., illustrated in FIG. 1A. A third main direction Y of the process gas flow path within the pumping region may be a direction opposite to the first main direction X.

At least one evacuation outlet 140 may be arranged in an outer wall of the source housing 120 in such a way that an evacuation device, e.g. a vacuum pump, may be connected thereto. The evacuation outlet 140 may be located in a lateral outer wall and/or in a rear outer wall opposing the open front side of the source housing. In the embodiment shown in FIG. 1A, the evacuation outlet is located in the rear outer wall opposing the open front side, because the rear outer wall may provide for sufficient installation space for connecting a vacuum pump, even after the deposition source 100 has been mounted to a process chamber.

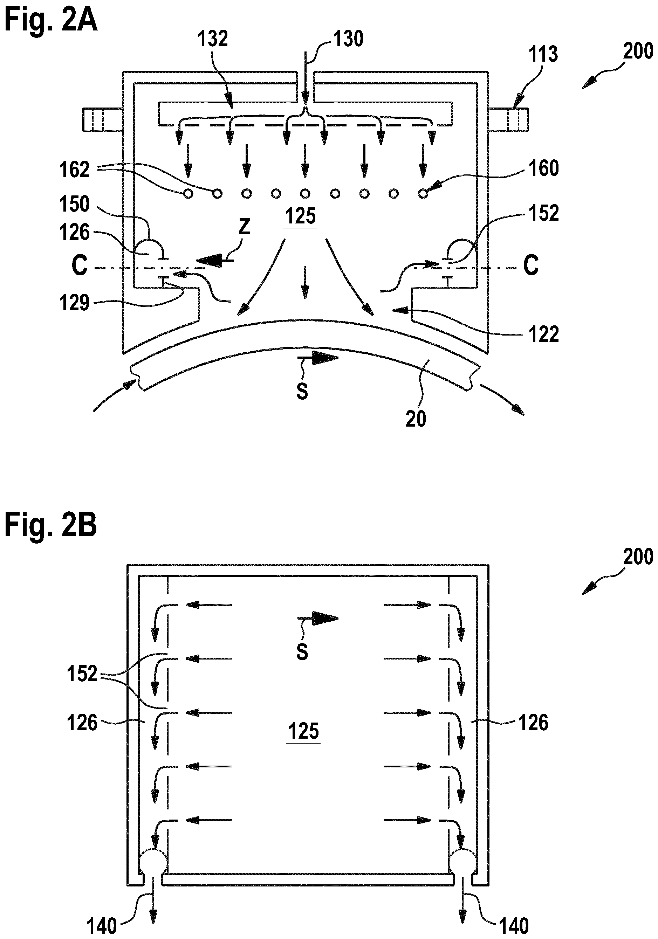

Next, with reference to FIG. 2A and FIG. 2B, a deposition source 200 according to embodiments will be described. The basic configuration of the source housing 120 of the deposition source 200 corresponds to the configuration of deposition source 100, so that reference can be made to the above explanations.

The deposition source 200 can be configured for hot wire chemical vapour deposition (HWCVD). For this reason, a wire assembly 160 including one or more heating wires 162 is arranged in the coating processing region 125. The process gas flow path runs through spaces between the wires 162 so that the process gas may be preheated before reaching the substrate 20. In some embodiments, the wires are arranged between the gas inlet 130 and the open front side 122 so that the process gas flow path passes therethrough.

The deposition source may implement a heating wire or heating filament as a hot element for improved coating results. In particular, several heating wires may be heated to a sufficiently high temperature. Generally, the process gas interacts with the heated wires (e.g. by flowing over or coming into physical contact with a wire) before reacting on the substrate surface. The interaction of the material to be deposited with the heated wire may induce a physical and/or chemical transformation on the deposition material, which is generally referred to as a deposition precursor. For example, the heated wire may induce a temperature increase of the process gas such that the process gas is decomposed through a chemical reaction.

The wire assembly 160 shown in FIG. 2A includes a total of nine wires arranged between the gas inlet 130 and the substrate 20, the individual wires 160 running parallel to a substrate surface and/or perpendicular to the process gas flow path. However, in other embodiments, more or less than nine wires may be provided, e.g. a number between 5 and 30 wires.

In embodiments, the deposition source may be provided with an actuator system with a motorized drive for tensioning the wires during coating. Such an actuator system including a motorised drive facilitates a proper wire tensioning and prevents excessive stress on the wires. According to yet further embodiments, which can be combined with other embodiments described herein, the actuator system can also be utilized for feeding the wires in the coating processing region, in which the wires are heated. Alternatively or additionally, a spring tensioning system coupled to the wires for tensioning may be implemented.

According to typical embodiments, a wire is an elongated piece of filament (slender and/or string-like) including material suitable for being heated. For example, but not limited thereto, the wire may be made of a flexible material including a resistive material that may be heated to a suitable operating temperature by the passage of electric current.

In some embodiments, a wire roller system configured for feeding and correctly positioning the wires is provided. Further, a feed control system may be provided configured for automatically supplying a new wire portion during coating and/or at predetermined time intervals.

Typically, a distance between the wires 162 and the substrate 20 during processing (or between the wires 162 and the open front side 122 of the source housing 120) is between 40 mm and 80 mm, particularly about 60 mm. Typically, a distance between the wires 162 and the gas inlet 130, which may be provided as a showerhead assembly 132, is between 40 mm and 150 mm, particularly between 60 mm and 100 mm. In embodiments, a distance between the wires 162 and a showerhead assembly for introducing the process gas may be made adjustable, in order to adapt the process gas flow path to various coating conditions and/or coating and substrate materials. For example, in a first operating position the distance between the wires 160 and the showerhead assembly may be 60 mm, in a second operating position the distance between the wires and the showerhead assembly may be 80 mm, and in a third operating position the distance between the wires and the showerhead assembly may be 100 mm.

It is noted that the wire assembly 160 is an optional feature and the deposition source 200 is not necessarily adapted for performing HWCDV. For example, the deposition source 200 may alternatively or additionally be adapted to perform other CVD techniques, e.g. PECVD. However, particular benefits with regard to process gas flow uniformity can be achieved by providing a HWCVD deposition source for roll-to-roll applications with an evacuation partition unit 150 as described herein.

In the embodiment shown in FIG. 2A, the gas inlet 130 is provided as a gas distribution system such as, e.g., a showerhead assembly 132, with a plurality of holes for introducing the process gas in a uniform and homogenous manner into the coating processing region 125. The one or more holes of the showerhead assembly may include one or more nozzles.

A gas distribution system or showerhead assembly can be understood herein to include an enclosure having holes such that the pressure in an inner volume of the enclosure is higher than the pressure outside the inner volume, e.g. in the coating processing region of the source housing during processing, where the showerhead assembly is arranged, for example by at least one order of magnitude. In one example, the pressure in the inner volume of the enclosure during processing may be between about 10⁻² to 10⁻¹mbar, or between about 10⁻² to about 10⁻³ mbar. According to some embodiments, the pressure in the coating processing region may be between about 10⁻⁵ to about 10⁻⁷ mbar.

The showerhead assembly 132 may be heatable in order to preheat or temper the process gas streaming therethrough. For example, the showerhead assembly 132 may be provided with tempering channels for a tempering fluid.

However, it is noted that the showerhead assembly is an optional, though beneficial feature and may be omitted in some embodiments. For example, the deposition source 200 shown in FIG. 2a may alternatively be provided with a single gas inlet opening or gas inlet tube similar to the gas inlet shown in FIG. 1A. Such a deposition source would not be in accordance with the claimed invention.

In some implementations, the gas inlet 130 is located at a rear side of the source housing 120, so that the process gas stream path extends from the rear side of the source housing through to the front side of the source housing.

According to some embodiments, which may be combined with other embodiments described herein, the plurality of openings 152 are arranged side by side in a linear arrangement. Such a linear arrangement of openings 152 is shown in the sectional view of FIG. 2B, the cross-sectional plane running along the line C-C indicated in FIG. 2A, which intersects through the openings 152.

A linear arrangement of openings side-by-side is particularly beneficial in the case of a deposition source for coating a movable substrate, because the openings may be arranged at a substrate entrance side and/or at a substrate exit side of the open front side 122. In some embodiments, which may be combined with other embodiments described herein, the open front side of the source housing may be provided with a substantially rectangular opening, wherein the plurality of openings extends linearly along at least one side of the rectangular opening, particularly along a side extending perpendicular to the substrate moving direction S so that the process gas may be sucked into the openings after having reacted on the substrate in a homogenous way along the width of the substrate 20.

In some embodiments, the evacuation partition unit 150 has a first plurality of openings 152 on a first lateral side of the coating processing region and a second plurality of openings on a second lateral side of the coating processing region opposing the first lateral side. The first plurality of openings may be arranged in a linear side-by-side arrangement next to a substrate entrance side of the source housing front opening, and the second plurality of openings may be arranged in a linear side-by-side arrangement next to a substrate exit side of the source housing front opening, as is illustrated in the sectional view of FIG. 2B. Approximately half of the process gas, after having reacted on the substrate surface, streams parallel to the substrate moving direction S through the first plurality of openings into a first portion of the pumping region 126, and the other half of the process gas, after having reacted on the substrate surface, streams in the opposite direction through the second plurality of openings into a second portion of the pumping region 126. In some embodiments, the openings may be provided in the wall of at least one suction pipe arranged within the source housing 120.

In the embodiment shown in FIGS. 2A and 2B, a process gas flow path direction Z leading through the openings 152 is essentially perpendicular to a main direction of the process gas flow path within the pumping regions 126, as is shown in FIG. 2B. Further, the main direction of the process gas flow path within the pumping region 126 is parallel to the extension direction of the linear arrangement of the plurality of openings 152. The evacuation outlet 140 may be arranged at least at one end of the linear arrangement of openings 152. Thus, a given amount of process gas streams through every opening into the pumping region and overlays with the gas amount coming through the neighbouring openings, so that the gas pressure may decrease within the pumping region as a function of the distance from the evacuation outlet 140. This "serial" process gas entrance into the pumping region may lead to a gas jam in the pumping region, at least when the cross section of the pumping region is not sufficiently large.

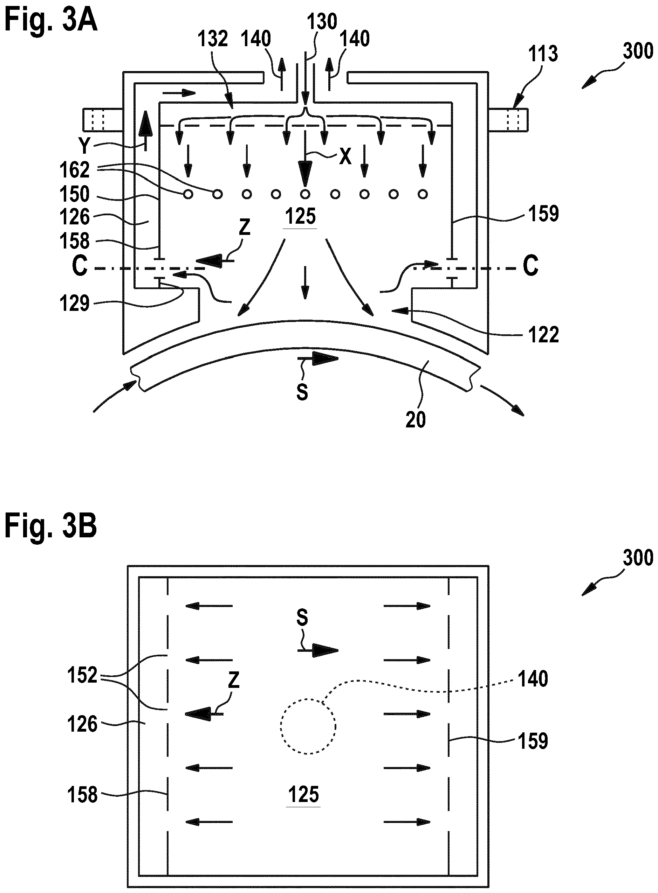

This problem may be overcome by providing a pumping region configuration and a gas outlet 140 position as shown in FIG. 3A and FIG 3B. FIG. 3A shows a sectional view of a deposition source 300 for coating a movable substrate according to embodiments described herein, and FIG. 3B shows the deposition source 300 in a lateral cross section along C-C indicated in FIG. 3A. The basic configuration of the source housing 120 of deposition source 300 corresponds to the configuration of deposition source 200, so that reference can be made to the above explanations. Optionally, the deposition source 300 may be provided as a HWCVD deposition source with a wire arrangement 160 and/or with a showerhead assembly 132.

In the embodiment shown in FIG. 3A and FIG. 3B, the evacuation outlet 140 is arranged at the rear side of the source housing opposite the open front side 122. The gas inlet 130, which may be provided with a showerhead 132, may also be arranged at the rear chamber side. In other words, in some implementations, both the gas inlet 130 and the evacuation outlet 140 may be arranged at the same side of the source housing 120. This side may provide for sufficient installation space. This is because the rear side does not face the substrate and may be directed towards the outside of a process chamber to which the deposition source may be attached. An exhaust line or exhaust tube can therefore easily be attached to the evacuation outlet 140.

In order to allow for the evacuation outlet 140 to be arranged at the rear chamber side, a first main direction X of the process gas flow path within the coating processing region 125 (rear-front-direction) may be opposed to a second main direction Y of the process gas flow path within the pumping region (front-rear-direction). In particular, after having reached the substrate 20, the process gas flow path may reverse direction and return through the pumping region back towards the rear side of the source housing, where the evacuation outlet may be arranged. The openings may be arranged at a side of the coating processing region 125, so that the process gas flow direction Z within the openings (sideway direction) may be essentially perpendicular the first and second main directions X, Y.

The evacuation partition unit 150 may include two gas shielding plates 158 and 159, which are arranged to linearly extend along a first side of the coating processing region 125 and along a second side of the coating processing region, which may be opposite the first side. The process gas may return to the rear chamber side "behind" the gas shielding plates 158, 159, through lateral edge regions formed between the gas shielding plates 158, 159 and outer side walls of the source housing. For example, the first gas shielding plate 158 may extend essentially parallel to a first outer side wall of the source housing at a close distance thereto, and the second gas shielding plate 159 may extend essentially parallel to a second outer side wall of the source housing opposed to the first outer side wall at a close distance thereto.

Each gas shielding plate 158, 159 may be provided with a plurality of openings 152 which form the process gas flow path 155 between the coating processing region 125 and a respective section of the pumping region 126.

In contrast to the embodiment shown in FIG. 2B, the main direction Y of the process gas flow path in the pumping region extends perpendicularly to an extension direction of the arrangement of openings in the embodiment shown in the embodiments shown in FIG. 3B. Thus, the gas amounts streaming through neighbouring openings are sucked away in parallel towards the evacuation outlet 140, so that the probability of a gas jam generation may be reduced.

Further, in embodiments described herein, a first gas flux density in a first sectional plane perpendicularly intersecting the process gas flow path in the pumping region near the openings 152 and a second gas flux density in a second sectional plane perpendicularly intersecting the process gas flow path in the pumping region further away from the openings 152 may be essentially identical. In some embodiments, the gas flux densities behind the individual openings 152 in the pumping region 126 may vary by less than 50%, in particular by less than 20%. A uniform suction efficiency can be provided.

The evacuation outlet 140 may be arranged at a center position in the rear side wall of the source housing in the substrate moving direction S. In particular, in the sectional plane shown in FIG. 3A (parallel to the rear-front direction and parallel to the substrate moving direction S), a first distance between the first plurality of openings and the centrally positioned evacuation outlet 140 may essentially correspond to a second distance between the second plurality of openings and the evacuation outlet 140. The term "essentially" as used herein may mean that a ratio between the first distance and the second distance is between 0.8 and 1.2.

In some embodiments disclosed herein, the evacuation partition unit 150 is fixed to at least a first side of the showerhead assembly 132 and particularly to two opposing sides of the showerhead assembly 132 and at least partially extends towards the open front side 122 of the source housing, laterally confining the coating processing region 125. As is shown in FIG. 3A the first gas shielding plate 158 is fixed to a left side of the showerhead 132 and protrudes into an inner volume of the source housing 120 towards the open front side 122, whereas the first plurality of openings 152 may be formed between a front edge of the first gas shielding plate 158 and a contact surface 129 of the source housing 120. Similarly, the second gas shielding plate 159 may be fixed to a right side of the showerhead 132 and protrude parallel to the first gas shielding plate 158 into the inner volume of the source housing 120 towards the open front side 122. The second plurality of openings may be formed between a front edge of the second gas shielding plate 159 and a contact surface of the source housing 120.

In some embodiments the front edge of at least one gas shielding plate may be formed with recesses, for example with a plurality of slots, which form the openings 152 when the front edge lies against the contact surface 129 of the source housing 120. In particular, both gas shielding plates 158, 159 may have notched front edges for abutting against the contact surface 129, wherein the process gas flow path is formed between the notched front edge and the contact surface. For example, the gas shielding plates may be provided with notched trowel-like front edges.

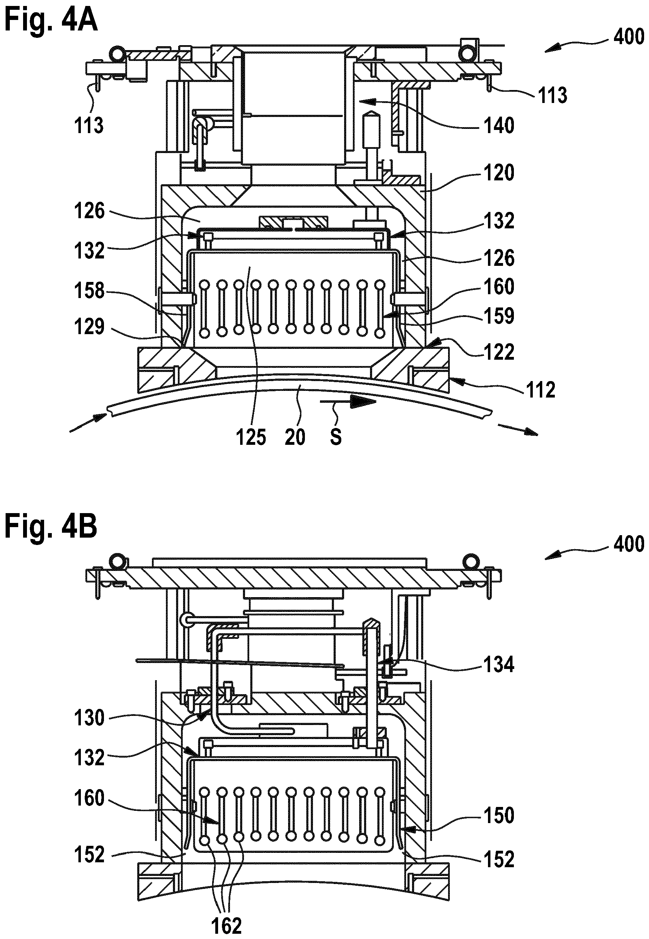

FIG. 4A shows a detailed sectional view of a deposition source 400 for coating a movable substrate, wherein the sectional plane runs through a closed portion of the evacuation partition unit 150, according to embodiments. FIG. 4B shows a detailed sectional view of the deposition source 400, wherein the sectional plane runs through an opening 152 of the evacuation partition unit. The configuration of the deposition source 400 is similar to the configuration of deposition source 300 explained above with reference to FIG. 3A and FIG. 3B, so that reference can be made to the above explanation which are not repeated here.

The deposition source 400 includes a source housing 120 with an open front side 122 provided with an opening for a flexible substrate 20 to be moved past the opening during coating in a substrate moving direction S. A frame 112 provided with the front opening may be fixed to a front side of a body of the source housing, wherein the front side of the frame 112 may be curved or rounded in order to ensure a close distance between the source housing and the substrate, which may be held on the moving surface of a processing drum (not shown). In particular, a curvature of the processing drum may correspond to a curvature of the curved front side of the frame 112. In particular, in some implementations, more than one deposition source may be installed to the side of a processing drum for coating the substrate with a stack of layers, whereas a gas flow from a first deposition source into a neighboring deposition source needs to be prevented. In order to prevent such an undesired gas flow, the frame 112 may be configured as a gas separation frame, wherein a slit between the substrate 20 and the frame 112 may be set as small as possible. For example, the frame 112 may be provided with an adjusting element for adjusting a width of the slit between the substrate 20 and the frame 112. Further, in some embodiments, the frame 112 may be provided with suction channels for connecting to an evacuation device, so that a process gas flow between the individual deposition sources can be prevented.

A graphite foil may be arranged between the frame 112 and the body of the source housing.

A gas inlet with a showerhead 132 is arranged at a rear side of the source housing 120 for introducing a process gas into the coating processing region 125 of the source housing 120. Further, an evacuation outlet 140 for removing the process gas from the pumping region 126 of the source housing 120 is also arranged at the rear chamber side at a central position in the substrate moving direction S.

An evacuation partition unit 150 with two gas shielding plates 158, 159 is arranged between the coating processing region 125 and the pumping region 126, each gas shielding plate 158, 159 being arranged with a plurality of openings 152 defining a process gas flow path from the coating processing region 125 into the pumping regions 126.

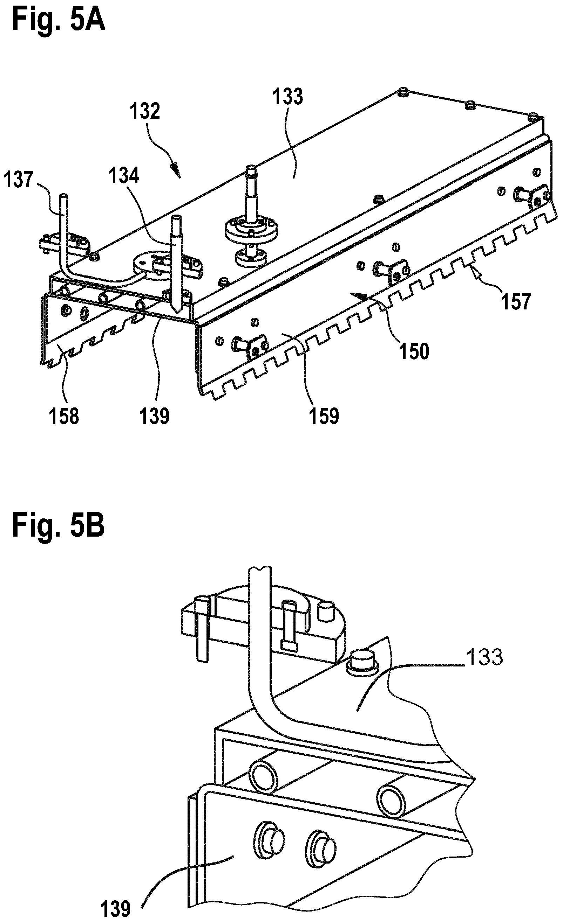

As is shown in detail in FIG. 5A, the gas shielding plates 158, 159 may be fixed to two opposite sides of the showerhead assembly 132 to extend towards the open front side 122 of the source housing 122, laterally confining the coating processing region 125. Further, the gas shielding plates 158, 159 may be provided with a notched front edge, wherein the plurality of openings 152 is formed to linearly extend between the notched front edge and a contact surface 129 of the source housing 120.

The pumping region 126 may extend between the arrangement consisting of the showerhead assembly 132 and the gas shielding plates 158, 159 and an outer wall of the source housing 120. In other words, the pumping region 126 may be located at least partially both "behind" the gas shielding plates 158, 159 and "above" the showerhead assembly 132, whereas the evacuation outlet 140 may be arranged at a central position above the showerhead assembly 132. Further, the process gas may stream essentially in parallel (and not serially) from the respective openings towards the evacuation outlet 140 so that a gas jam in the pumping region may be effectively prevented.

The deposition 400 source may be provided with fastening elements 113 for attaching the source housing 120 directly or indirectly to a process chamber in a gas-tight manner. For example the source housing 120 may be partially or entirely arranged in the process chamber after attachment, so that a gas-tight vacuum chamber arrangement to be evacuated can be formed by attaching the source housing 120 to the process holding chamber.

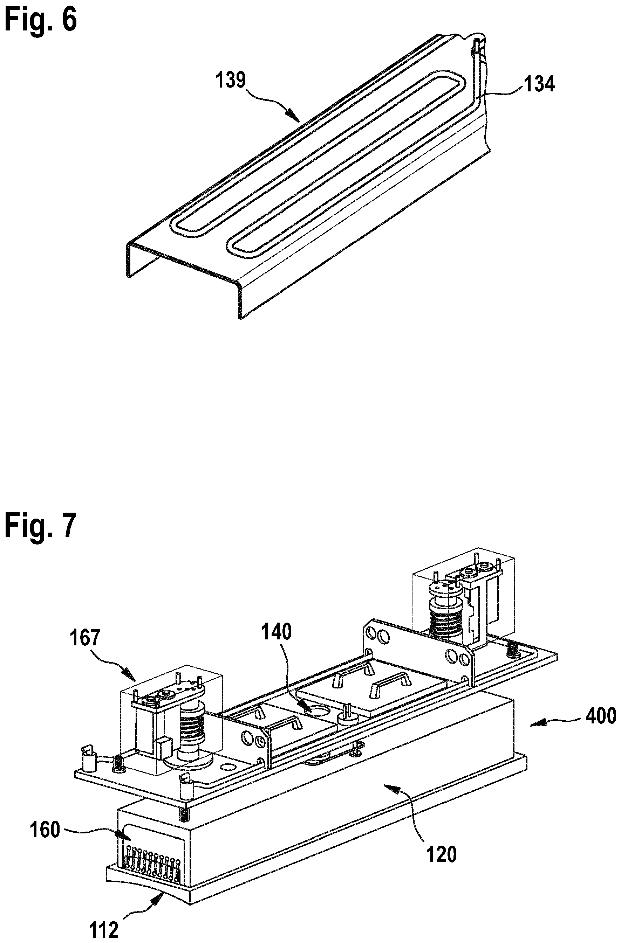

Details of a showerhead assembly 132 which may be used in some of the embodiments described herein are shown in FIG. 5A, FIG. 5B and FIG. 6. The showerhead assembly 132 may include a showerhead tempering 134 for pre-heating the process gas streaming through the showerhead assembly. The showerhead tempering 134 can include tempering channels attached to, e.g. soldered to, one or more surfaces of the showerhead assembly 132, which may come into contact with the process gas. Further, the showerhead assembly 132 may include a process gas input channel 137 for leading the process gas into a gas distribution volume of the showerhead assembly 132 formed between a cover plate 133 and a showerhead base 139. The showerhead base 139 with attached tempering coils of the showerhead tempering 134 is shown in detail in FIG. 6. The cover plate 133 may be indirectly tempered, when the cover plate 133 contacts the showerhead base 139.

The showerhead assembly may be made of or comprise a heat conductive material, e.g. a metal. For example, the showerhead assembly may be made of or comprise CuF, particularly SF-CuF25.

A main surface of the showerhead base 139 may be provided with a plurality of small holes for evenly distributing the process gas in the coating processing region 125. A diameter of the holes may be in the range from 1 mm to 4 mm, particularly about 2 mm. Alternatively or additionally, a distance between adjacent holes may be in the range from 10 mm and 50 mm, particularly about 22 mm. Alternatively or additionally, the shape of the showerhead base 139 provided with the holes may be rectangular. A width of the showerhead assembly 132, which may essentially correspond to a width of the coating processing region 125, which may essentially correspond to a width of the substrate to be coated may be in the range between 1 m and 2 m, particularly about 1.65 m. A length of the showerhead assembly 132, which may essentially correspond to a length of the coating processing region 125 may be in the range between 0.1 m and 0.5 m, particularly about 0.22 m.

The holes may be arranged in the showerhead assembly 132 in such a way that a straight line between each hole and the substrate perpendicular to a main surface of the showerhead assembly intersects the wire assembly 160 essentially centrally between two wires 162, respectively. Gas flow anomalies due to the wires 162 in the gas flow path may be prevented.

In the embodiment shown in FIG. 5A, the gas shielding plates 158, 159 are fixed to two sides of the showerhead assembly 132. For example, the gas shielding plates may be bolted to plate sections of showerhead assembly 132 protruding at right angles from a main surface. Several bolt holes may be provided in order to allow for a height adjustment. For example, a distance between the main surface of the showerhead base 139 and the front edge of the gas shielding plates may be set to 60 mm, 80 mm or 100 mm. For example, the assembly formed by the gas shielding plates 158, 159 and the showerhead 132 may form an elongated U-shaped shielding plate which separates the coating processing region from the pumping region. In embodiments, the pumping region may extend between said assembly and the outer side and rear walls of the source housing.

However, in some embodiments, which may be combined with other embodiments described herein, the gas shielding plates 158, 159 may be formed integrally with at least a part of the showerhead assembly 132, for example with the showerhead base 139. An integral design allows for a better heat conductance from the showerhead tempering 134 to the gas shielding plates 158, 159. In some embodiments provided with an integral design of the showerhead assembly and the gas shielding plates, a distance between the main surface of the showerhead base and the front edges of the integrally formed gas shielding plates may be 50 mm, 75 mm or 100 mm.

FIG. 7 is a detailed perspective view of the deposition source 400 according to embodiments described herein. The deposition source 400 includes a rectangular shaped source housing 120 with a frame 112 for gas separation at a front side. The source housing 120 may protrude into an inner volume of a process chamber towards a substrate support such as a coating drum.

The deposition source 140 may include a heating wire assembly 160 which allows for HWCVD operation. A wire drive 167 may be arranged outside the source housing 120 for energizing and/or controlling the wires of the wire assembly 160.

An evacuation outlet 140 is located at the rear side of the source housing 120 for evacuating an inner chamber volume.

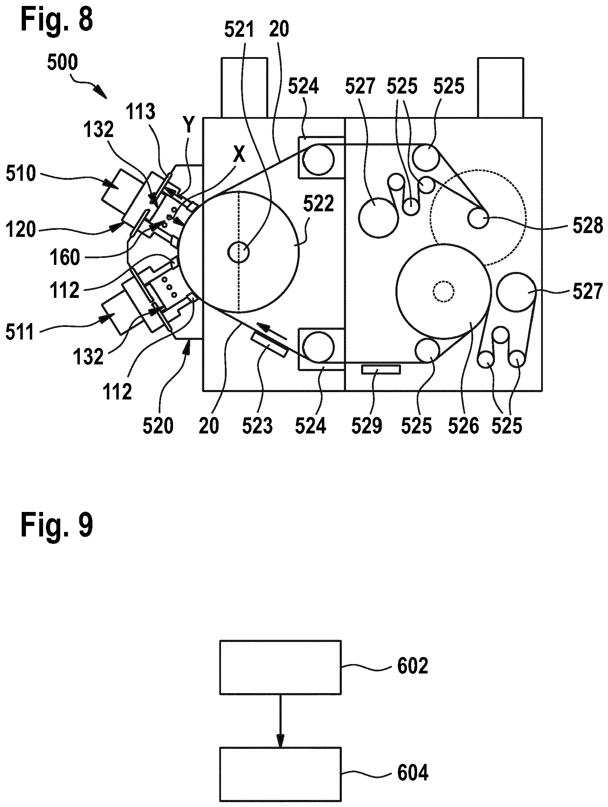

A deposition apparatus 500 for coating a movable substrate according to embodiments described herein is shown in a schematic view in FIG. 8. The deposition apparatus 500 includes a process chamber 520, a first deposition source 510 and a second deposition source 511. The deposition sources are directly or indirectly attached to the process chamber 520 via fastening elements 113 in a gas tight-manner in such a way that the deposition sources at least partially protrude into an inner volume of the process chamber 520 towards a substrate support.

The substrate support may be provided as a coating drum 522 configured to rotate about a rotation axis 521. The substrate support may be provided with a substrate guiding surface for moving a flexible substrate 20 past open front sides of source housings 120 or process housings of the deposition sources in succession.

At least the first deposition source 510 may be configured as a deposition source 100, 200, 300, 400 according to one of the above described embodiments, so that reference can be made to the above explanations and features which are not repeated here. The source housing 120 of the first deposition source 510 may include a gas inlet for introducing a process gas into a coating processing region of the source housing, an evacuation outlet for removing the process gas from a pumping region of the source housing, and an evacuation partition unit arranged between the coating processing region and the pumping region with at least one opening and particularly a plurality of openings defining a process gas flow path from the coating processing region into the pumping region.

In some embodiments, both the gas inlet and the evacuation outlet may be arranged at a rear side of the source housing 120 which may face away from the coating drum 522. The pumping region may consist of two side regions of the inner volume of the source housing 120, wherein a first main direction X of the process gas flow path within the coating processing region is a direction opposite to a second main direction Y of the process gas flow path within the pumping region.

The gas amounts streaming through adjacent openings in the evacuation partition unit may stream in parallel in the second main direction Y within the pumping region towards the rear side of the source housing. An essentially constant gas flux density may be ensured in the side regions of the pumping region so that a gas jam can be prevented.

In some embodiments a pre-treatment plasma source 523, e.g. an RF plasma source, can be provided to treat the substrate 20 with a plasma prior to being moved past the deposition sources. Alternatively or additionally, the deposition apparatus 500 can include a pre-heating unit 529 to heat the flexible substrate 20. A radiation heater, an e-beam heater or any other element to heat the substrate prior to processing thereof can be provided.

Gap sluices 524 which are capable of ensuring a vacuum separation between portions of the process chamber 520 may be additionally provided. The substrate 20 may be wound from a first roll 528 and may be transported over a number of interleaf rollers 525 to the coating drum 522 where the substrate is coated. Then, the substrate may be transported over further interleaf rollers 525 to a second roll 526. In addition, interleaf rolls 527 may be provided.

According to a further aspect, a method of operating a deposition apparatus for coating a movable substrate is provided. An exemplary flow diagram for illustrating the method is shown in FIG. 9. The method may be performed utilizing a deposition apparatus according to embodiments described herein.

In box 602, a substrate is moved past an open front side of a source housing, while a process gas is introduced into a coating processing region of the source housing for coating the substrate while being moved. The process gas follows a process gas flow path from the coating processing region into a pumping region of the source housing through at least one opening and particularly through a plurality of openings of an evacuation partition unit arranged between the coating processing region and the pumping region. In box 604, the process gas is removed from the pumping region, e.g. using an evacuation unit such as a vacuum pump.

The method may further include some or all of the activities described with reference to the above embodiments, and they are not repeated here.

According to embodiments described herein, deposition sources as follows are provided:
1. A deposition source for coating a movable substrate, comprising: a source housing to be fixed to a process chamber in such a way that a substrate can be moved past an open front side of the source housing during deposition; a gas inlet for introducing a process gas into a coating processing region of the source housing; an evacuation outlet for removing the process gas from a pumping region of the source housing; and an evacuation partition unit arranged between the coating processing region and the pumping region with at least one opening defining a process gas flow path from the coating processing region into the pumping region.
2. The above deposition source, wherein the evacuation partition unit has at least one plurality of openings defining the process gas flow path.
3. Any of the above deposition sources, wherein the at least one plurality of openings are arranged side by side in a linear arrangement.
4. Any of the above deposition sources, wherein a main direction of the gas flow path within the pumping region is perpendicular to an extension direction of the linear arrangement.
5. Any of the above deposition sources, wherein the evacuation partition unit has a first plurality of openings on a first lateral side of the coating processing region and a second plurality of openings on a second lateral side of the coating processing region opposed to the first lateral side in a substrate moving direction.
6. Any of the above deposition sources, wherein, in a sectional plane, a first distance between the first plurality of openings and the evacuation outlet corresponds to a second distance between the second plurality of openings and the evacuation outlet.
7. Any of the above deposition sources, wherein a first main direction of the process gas flow path within the coating processing region is a direction opposite to a second main direction of the process gas flow path within the pumping region and particularly perpendicular to a third main direction of the process gas flow path within the openings.
8. Any of the above deposition sources, wherein the gas inlet and/or the evacuation outlet are arranged at a rear side of the source housing opposite to the open front side.
9. Any of the above deposition sources, wherein the evacuation partition unit is provided with at least one gas shielding plate.
10. Any of the above deposition sources, wherein a first gas shielding plate is arranged to linearly extend along a first side of the coating processing region, and a second gas shielding plate is arranged to linearly extend along a second side of the coating processing region.
11. Any of the above deposition sources, wherein each gas shielding plate provides at least one opening and particularly a plurality of openings between the coating processing region and the pumping region.
12. Any of the above deposition sources, wherein the at least one gas shielding plate has a notched front edge lying against a contact surface of the source housing, wherein the process gas flow path is formed between the notched front edge and the contact surface.
13. Any of the above deposition sources, wherein the gas inlet is provided as a showerhead assembly arranged in the coating processing region opposed to the open front side.
14. Any of the above deposition sources, wherein at least a portion of the showerhead assembly separates the coating processing region from the pumping region.
15. Any of the above deposition sources, wherein at least a portion of the pumping region extends between the showerhead assembly and a rear outer wall of the source housing.
16. Any of the above deposition sources, wherein the evacuation partition unit at least partially extends from a rear side of the source housing towards the open front side of the source housing, laterally confining the coating processing region.
17. Any of the above deposition sources, wherein two gas shielding plates are fixed to two opposite sides of the showerhead assembly.
18. Any of the above deposition sources, wherein at least a portion of the pumping region is formed between a gas shielding plate and an outer side wall of the coating processing chamber.
19. Any of the above deposition sources, wherein at least one gas shielding plate is formed integrally with at least a portion of the showerhead assembly.
20. Any of the above deposition sources, wherein an adjusting element is provided for adjusting a distance between a main surface of the showerhead assembly and the at least one opening of the evacuation partition unit.
21. Any of the above deposition sources, wherein the showerhead assembly includes a showerhead tempering.
22. Any of the above deposition sources, wherein the showerhead tempering includes one or more tempering channels or tempering coils attached to a main surface of the showerhead assembly.
23. Any of the above deposition sources, wherein the source housing has an essentially rectangular shape.
24. Any of the above deposition sources, wherein a width of the source housing is in a range between 1 m and 2 m and/or wherein a length of the source housing is in a range between 0.2 m and 0.5 m.
25. Any of the above deposition sources, which is configured for CVD operation.
26. Any of the above embodiments, which is configured for PECVD operation and/or HWCVD operation.
27. Any of the above deposition sources, wherein the evacuation partition unit has more than 10 and less than 100 openings, in particular more than 20 and less than 50 openings.
28. Any of the above deposition sources, wherein two gas shielding plates are provided which extend parallel to outer side walls of the source housing.
29. Any of the above deposition sources, which is provided with mechanical springs and/or with a motorized drive for tensioning at least a heating wire of a wire assembly.
30. Any of the above deposition sources, which is provided with a showerhead assembly comprising or consisting of a metal.
31. Any of the above deposition sources, which is provided with a showerhead assembly comprising or consisting of CuF.
32. Any of the above deposition sources, wherein a wire assembly comprising one or more heating wires is arranged in the coating processing region, particularly between the showerhead assembly and the open front side.
33. Any of the above deposition sources, wherein an open front side of the source housing is curved in order to allow for a curved substrate to be moved past the open front side.
34. Any of the above deposition sources, wherein the source housing comprises a body and a frame fixed to a front of the body, wherein a front side of the frame is curved to allow for a curved substrate to be moved past the open front side of the source housing.
35. A deposition apparatus for coating a movable substrate, comprising: a source housing fixed to a process chamber provided with a substrate support, the substrate support comprising a substrate guiding surface for moving a substrate past an open front side of the source housing; a gas inlet for introducing a process gas into a coating processing region of the source housing; an evacuation outlet for removing the process gas from a pumping region of the source housing; and an evacuation partition unit arranged between the coating processing region and the pumping region with at least one opening and particularly a plurality of openings defining a process gas flow path from the coating processing region into the pumping region.
36. The above deposition apparatus, further comprising an evacuation unit, e.g. a vacuum pump, connected to the evacuation outlet.
37. The above deposition apparatus, further comprising a second, a third or further deposition sources with source housings fixed to the coating chamber in succession.
38. The above deposition apparatus, wherein the substrate support includes a rotatable coating drum.
39. The above deposition apparatus, wherein a curvature of an open front side of the source housing is adapted to a curvature of the substrate guiding surface of the coating drum.
40. The above deposition apparatus, further comprising one or more gap sluices for ensuring a vacuum separation between inner portions of the process chamber.
41. The above deposition apparatus, further comprising the substrate to be coated which extends from a first roll within the process chamber via a substrate guiding surface of a coating drum towards a second roll.
42. The above deposition apparatus, further comprising the substrate provided as a flexible substrate, e.g. as a web, a foil or a strip.
43. The above deposition apparatus, further comprising one or more vacuum pumps for evacuating the process chamber.

The scope of the invention is determined by the claims that follow.

## Claims

1. A deposition source (100) for coating a movable substrate, comprising:
a source housing (120) to be attached to a process chamber in such a way that a substrate (20) can be moved past an open front side (122) of the source housing during deposition;
a gas inlet (130) for introducing a process gas into a coating processing region (125) of the source housing (120), wherein the gas inlet is provided as a showerhead assembly (132) arranged in the coating processing region (125) opposed to the open front side (122);
an evacuation outlet (140) for removing the process gas from a pumping region (126) of the source housing (120); and
an evacuation partition unit (150) arranged between the coating processing region (125) and the pumping region (126) with at least one opening (152) defining a process gas flow path (155) from the coating processing region (125) into the pumping region (126).

2. The deposition source of claim 1, wherein the evacuation partition unit (150) has at least one plurality of openings (152) defining the process gas flow path.

3. The deposition source of claim 2, wherein the at least one plurality of openings (152) are arranged side by side in a linear arrangement.

4. The deposition source of claim 3, wherein a main direction (Y) of the process gas flow path within the pumping region (126) is perpendicular to an extension direction of the linear arrangement.

5. The deposition source of any of claims 2 to 4, wherein the evacuation partition unit (150) has a first plurality of openings on a first lateral side of the coating processing region (125) and a second plurality of openings on a second lateral side of the coating processing region opposing the first lateral side in a substrate moving direction (S).

6. The deposition source of any of claims 1 to 5, wherein a first main direction (X) of the process gas flow path within the coating processing region (125) is a direction opposite a second main direction (Y) of the process gas flow path within the pumping region and particularly perpendicular to a third main direction (Z) of the process gas flow path within the openings (152).

7. The deposition source of any of claims 1 to 6, wherein the gas inlet (130) and/or the evacuation outlet (140) are arranged at a rear side of the source housing (120) opposed to the open front side (122).

8. The deposition source of any of claims 1 to 7, wherein the evacuation partition unit (150) includes at least one gas shielding plate (158, 159).

9. The deposition source of claim 8, wherein a first gas shielding plate (158) is arranged to linearly extend along a first side of the coating processing region, and a second gas shielding plate (159) is arranged to linearly extend along a second side of the coating processing region, each gas shielding plate providing a plurality of openings (152) between the coating processing region and the pumping region.

10. The deposition source of claim 8 or 9, wherein the at least one gas shielding plate (158, 159) has a notched front edge (157) lying against a contact surface (129) of the source housing, wherein the process gas flow path (155) is formed between the notched front edge (157) and the contact surface (129).

11. The deposition source of any of claims 1 to 10, wherein the evacuation partition unit (150) is fixed to at least a first side of the showerhead assembly (132) and particularly to two opposing sides of the showerhead assembly (132) and at least partially extends towards the open front side (122) of the source housing, laterally confining the coating processing region (125).

12. The deposition source of any of claims 1 to 11, wherein a wire assembly (160) comprising one or more heating wires (162) is arranged in the coating processing region, particularly between the showerhead assembly and the open front side.

13. A deposition apparatus for coating a movable substrate, comprising:
a source housing (120) connected to a process chamber,
wherein the process chamber is provided with a substrate support, the substrate support comprising a substrate guiding surface for moving a substrate (20) past an open front side (122) of the source housing (120);
a gas inlet (130) for introducing a process gas into a coating processing region (125) of the source housing, wherein the gas inlet is provided as a showerhead assembly (132) arranged in the coating processing region (125) opposed to the open front side (122);
an evacuation outlet (140) for removing the process gas from a pumping region (126) of the source housing; and
an evacuation partition unit (150) arranged between the coating processing region and the pumping region with at least one opening and particularly a plurality of openings (152) defining a process gas flow path (155) from the coating processing region (125) into the pumping region (126).

14. A method of operating a deposition apparatus for coating a movable substrate, particularly a deposition apparatus of claim 13, comprising:
moving a substrate (20) past an open front side (122) of a source housing (120),
introducing a process gas into a coating processing region (125) of the source housing with a showerhead assembly (132) arranged in the coating processing region (125) opposed to the open front side (122), wherein the process gas follows a process gas flow path (155) from the processing region (125) into a pumping region (126) of the source housing through at least one opening and particularly a plurality of openings (152) of an evacuation partition unit (150) arranged between the coating processing region and the pumping region,
removing the process gas from the pumping region (126).

## Patentansprüche

1. Abscheidungsquelle (100) zur Beschichtung eines beweglichen Substrats, umfassend:
ein Quellengehäuse (120), das an einer Prozesskammer so zu befestigen ist, dass ein Substrat (20) an einer offenen Vorderseite (122) des Quellengehäuses während der Abscheidung bewegt werden kann;
einen Gaseinlass (130) zum Einführen eines Prozessgases in einen Beschichtungsbereich (125) des Quellengehäuses (120), wobei der Gaseinlass als eine Showerhead-Anordnung (132) vorgesehen ist, die in dem Beschichtungsbereich (125) gegenüber der offenen Vorderseite (122) angeordnet ist;
einen Entleerungsauslass (140) zum Entfernen des Prozessgases aus einem Pumpbereich (126) des Quellengehäuses (120); und
eine Entleerungstrenneinheit (150), die zwischen dem Beschichtungsbereich (125) und dem Pumpbereich (126) mit mindestens einer Öffnung (152) angeordnet ist, die einen Prozessgasstromweg (155) vom Beschichtungsbereich (125) in den Pumpbereich (126) definiert.

2. Abscheidungsquelle nach Anspruch 1, wobei die Entleerungstrenneinheit (150) mindestens eine Vielzahl von Öffnungen (152) aufweist, die den Prozessgasstromweg definieren.

3. Abscheidungsquelle nach Anspruch 2, wobei die mindestens eine Vielzahl von Öffnungen (152) Seite an Seite in einer linearen Anordnung angeordnet sind.

4. Abscheidungsquelle nach Anspruch 3, wobei eine Hauptrichtung (Y) des Prozessgasstromwegs innerhalb des Pumpbereich (126) senkrecht zu einer Erstreckungsrichtung der linearen Anordnung verläuft.

5. Abscheidungsquelle nach einem der Ansprüche 2 bis 4, wobei die Entleerungstrenneinheit (150) eine erste Vielzahl von Öffnungen auf einer ersten lateralen Seite des Beschichtungsbereichs (125) und eine zweite Vielzahl von Öffnungen auf einer zweiten lateralen Seite des Beschichtungsbereichs gegenüber der ersten lateralen Seite in einer Substratbewegungsrichtung (S) aufweist.

6. Abscheidungsquelle nach einem der Ansprüche 1 bis 5, wobei eine erste Hauptrichtung (X) des Prozessgasstromwegs innerhalb des Beschichtungsbereichs (125) eine Richtung entgegengesetzt zu einer zweiten Hauptrichtung (Y) des Prozessgasstromwegs innerhalb des Pumpbereichs und insbesondere senkrecht zu einer dritten Hauptrichtung (Z) des Prozessgasstrompfads innerhalb der Öffnungen (152) ist.

7. Abscheidungsquelle nach einem der Ansprüche 1 bis 6, wobei der Gaseinlass (130) und/oder der Entleerungsauslass (140) auf einer Rückseite des Quellengehäuses (120) gegenüber der offenen Vorderseite (122) angeordnet sind.

8. Abscheidungsquelle nach einem der Ansprüche 1 bis 7, wobei die Entleerungstrenneinheit (150) mindestens eine Gasabschirmplatte (158, 159) enthält.

9. Abscheidungsquelle nach Anspruch 8, wobei eine erste Gasabschirmplatte (158) derart angeordnet ist, dass sie sich linear entlang einer ersten Seite des Beschichtungsbereichs erstreckt, und eine zweite Gasabschirmungsplatte (159) derart angeordnet ist, dass sie sich entlang einer zweiten Seite des Beschichtungsbereichs erstreckt, wobei jede Gasabschirmplatte eine Vielzahl von Öffnungen (152) zwischen dem Beschichtungsbereich und dem Pumpbereich aufweist.

10. Abscheidungsquelle nach Anspruch 8 oder 9, wobei die mindestens eine Gasabschirmplatte (158, 159) eine genutete Stirnkante (157) hat, die an einer Kontaktfläche (129) des Quellengehäuses anliegt, wobei der Prozessgasstromweg (155) zwischen dem genuteten Stirnrand (157) und der Kontaktfläche (129) ausgebildet ist.

11. Abscheidungsquelle nach einem der Ansprüche 1 bis 10, wobei die Entleerungstrenneinheit (150) an mindestens einer ersten Seite der Showerhead-Anordnung (132) und insbesondere an zwei sich gegenüberliegenden Seiten der Showerhead-Anordnung (132) befestigt ist und sich zumindest teilweise in Richtung der offenen Vorderseite (122) des Quellengehäuses erstreckt und den Beschichtungsbereich (125) lateral beschränkt.

12. Abscheidungsquelle nach einem der Ansprüche 1 bis 11, wobei eine Drahtanordnung (160), die eine oder mehrere Erwärmungsdrähte (162) umfasst, in dem Beschichtungsbereich angeordnet ist, insbesondere zwischen der Showerhead-Anordnung und der offenen Vorderseite.

13. Abscheidungsvorrichtung zur Beschichtung eines beweglichen Substrats, umfassend:
ein Quellengehäuse (120), das mit einer Prozesskammer verbunden ist,
wobei die Prozesskammer mit einem Substratträger bereitgestellt ist, wobei der Substratträger eine Substratführungsfläche zum Bewegen eines Substrats (20) an einer offenen Vorderseite (122) des Quellengehäuses (120) umfasst;
einen Gaseinlass (130) zum Einleiten eines Prozessgases in einen Beschichtungsbereich (125) des Quellengehäuses, wobei der Gaseinlass als eine Showerhead-Anordnung (132) bereitgestellt ist, die in dem Beschichtungsbereich (125) gegenüber der offenen Vorderseite (122) angeordnet ist;
einen Entleerungsauslass (140) zum Entfernen von Prozessgas aus einem Pumpbereich (126) des Quellengehäuses; und
eine Entleerungstrenneinheit (150), die zwischen dem Beschichtungsbereich und dem Pumpbereich angeordnet ist, wobei mindestens eine Öffnung und insbesondere mehrere Öffnungen (152) einen Prozessgasstromweg (155) von dem Beschichtungsbereich (125) in den Pumpbereich (126) definieren.

14. Verfahren zum Betrieb einer Abscheidungsvorrichtung zur Beschichtung eines beweglichen Substrats, insbesondere einer Abscheidungsvorrichtung nach Anspruch 13, umfassend:
Bewegen eines Substrats (20) vorbei einer offenen Vorderseite (122) eines Quellengehäuses (120),
Einleiten eines Prozessgases in einen Beschichtungsbereich (125) des Quellengehäuses mit einer Showerhead-Anordnung (132), die in dem Beschichtungsbereich (125) gegenüber der offenen Vorderseite (122) angeordnet ist, wobei das Prozessgas einem Prozessgasstromweg (155) von dem Beschichtungsbereich (125) in einen Pumpbereich (126) des Quellengehäuses durch mindestens eine Öffnung und insbesondere eine Vielzahl von Öffnungen (152) einer Entleerungstrenneinheit (150) folgt, die zwischen dem Beschichtungsbereich und dem Pumpbereich angeordnet ist,
Entfernen von Prozessgas aus dem Pumpenbereich (126).

## Revendications

1. Source de dépôt (100) permettant de revêtir un substrat amovible, comprenant :
un logement de source (120) destiné à être attaché à une chambre de traitement de telle sorte qu'un substrat (20) peut être déplacé au-delà d'un côté frontal ouvert (122) du logement de source pendant le dépôt ;
une entrée de gaz (130) permettant d'introduire un gaz de procédé dans une région de traitement de revêtement (125) du logement de source (120), dans lequel l'entrée de gaz est munie d'un ensemble tête de douche (132) agencé dans la région de traitement de revêtement (125) à l'opposé du côté frontal ouvert (122) ;
une sortie d'évacuation (140) permettant d'éliminer le gaz de procédé à partir d'une région de pompage (126) du logement de source (120) ; et
une unité de partition d'évacuation (150) agencée entre la région de traitement de revêtement (125) et la région de pompage (126) avec au moins une ouverture (152) définissant une voie d'écoulement du gaz de procédé (155) à partir de la région de traitement de revêtement (125) dans la région de pompage (126).

2. Source de dépôt selon la revendication 1, dans laquelle l'unité de partition d'évacuation (150) présente au moins une pluralité d'ouvertures (152) définissant la voie d'écoulement du gaz de procédé.

3. Source de dépôt selon la revendication 2, dans laquelle l'au moins une pluralité d'ouvertures (152) est agencée côte à côte dans un agencement linéaire.

4. Source de dépôt selon la revendication 3, dans laquelle une direction principale (Y) de la voie d'écoulement du gaz de procédé au sein de la région de pompage (126) est perpendiculaire à une direction d'extension de l'agencement linéaire.

5. Source de dépôt selon l'une quelconque des revendications 2 à 4, dans laquelle l'unité de partition d'évacuation (150) présente une première pluralité d'ouvertures sur un premier côté latéral de la région de traitement de revêtement (125) et une pluralité d'ouvertures sur un second côté latéral de la région de traitement de revêtement faisant face au premier côté latéral dans une direction de déplacement de substrat (S) .

6. Source de dépôt selon l'une quelconque des revendications 1 à 5, dans laquelle une première direction principale (X) de la voie d'écoulement du gaz de procédé au sein de la région de traitement de revêtement (125) constitue une direction opposée à la seconde direction principale (Y) de la voie d'écoulement du gaz de procédé au sein de la région de pompage et particulièrement de manière perpendiculaire à une troisième direction principale (Z) de la voie d'écoulement du gaz de procédé au sein des ouvertures (152).

7. Source de dépôt selon l'une quelconque des revendications 1 à 6, dans laquelle l'entrée de gaz (130) et/ou la sortie d'évacuation (140) sont agencées au niveau d'un côté arrière du logement de source (120) à l'opposé du côté frontal ouvert (122) .

8. Source de dépôt selon l'une quelconque des revendications 1 à 7, dans laquelle l'unité de partition d'évacuation (150) inclut au moins une plaque de protection gazeuse (158, 159).

9. Source de dépôt selon la revendication 8, dans laquelle une première plaque de protection gazeuse (158) est agencée pour s'étendre de manière linéaire le long d'un premier côté de la région de traitement de revêtement, et une seconde plaque de protection gazeuse (159) est agencée pour s'étendre de manière linéaire le long d'un second côté de la région de traitement de revêtement, chaque plaque de protection gazeuse fournissant une pluralité d'ouvertures (152) entre la région de traitement de revêtement et la région de pompage.

10. Source de dépôt selon la revendication 8 ou 9, dans laquelle l'au moins une plaque de protection gazeuse (158, 159) présente un bord frontal dentelé (157) reposant contre une surface de contact (129) du logement de source, dans laquelle la voie d'écoulement du gaz de procédé (155) est formée entre le bord frontal dentelé (157) et la surface de contact (129).

11. Procédé selon l'une quelconque des revendications 1 à 10, dans laquelle l'unité de partition d'évacuation (150) est fixée à au moins un premier côté de l'ensemble tête de douche (132) et particulièrement à deux côtés s'opposant de l'ensemble tête de douche (132) et au moins s'étend partiellement en direction du côté frontal ouvert (122) du logement de source, limitant de manière latérale la région de traitement de recouvrement (125).

12. Procédé selon l'une quelconque des revendications 1 à 11, dans laquelle un ensemble câble (160) comprenant un ou plusieurs câbles de chauffage (162) est agencé dans la région de traitement de revêtement, particulièrement entre l'ensemble tête de douche et le côté frontal ouvert.

13. Dispositif de dépôt permettant de recouvrir un substrat amovible, comprenant :
un logement de source (120) relié à une chambre de traitement,
dans lequel la chambre de traitement est munie d'un support de substrat, le support de substrat comprenant une surface de guidage de substrat permettant de déplacer un substrat (20) au-delà d'un côté frontal ouvert (122) du logement de source (120) ;
une entrée de gaz (130) permettant d'introduire un gaz de procédé au sein d'une région de traitement de revêtement (125) du logement de source, dans lequel l'entrée de gaz est munie d'un ensemble tête de douche (132) agencé dans la région de traitement de revêtement (125) à l'opposé du côté frontal ouvert (122) ;
une sortie d'évacuation (140) permettant d'éliminer le gaz de procédé à partir d'une région de pompage (126) du logement de source ; et
une unité de partition d'évacuation (150) agencée entre la région de traitement de revêtement et la région de pompage avec au moins une ouverture et particulièrement une pluralité d'ouvertures (152) définissant une voie d'écoulement du gaz de procédé (155) à partir de la région de traitement de revêtement (125) dans la région de pompage (126).

14. Procédé de fonctionnement d'un appareil de dépôt permettant de recouvrir un substrat amovible, particulièrement un appareil de dépôt selon la revendication 13, comprenant :
déplacer un substrat (20) au-delà d'un côté frontal ouvert (122) d'un logement de source (120),
introduire un gaz de procédé au sein d'une région de traitement de revêtement (125) du logement de source muni d'un ensemble tête de douche (132) agencé dans la région de traitement de revêtement (125) à l'opposé du côté frontal ouvert (122), dans lequel le gaz de procédé suit une voie d'écoulement du gaz de procédé (155) à partir de la région de traitement (125) au sein d'une région de pompage (126) du logement de source à travers au moins une ouverture et particulièrement une pluralité d'ouvertures (152) d'une unité de partition d'évacuation (150) agencée entre la région de traitement de revêtement et la région de pompage,
éliminer le gaz de procédé à partir de la région de pompage (126) .
